Europäisches Patentamt

European Patent Office

Office européen des brevets

(11) Publication number: **0 248 445**
**A2**

# (12) EUROPEAN PATENT APPLICATION

(21) Application number: **87108180.8**

(22) Date of filing: **05.06.87**

(51) Int. Cl.⁴: **H01L 21/283** , **H01L 29/40**

A request for correction of page 2(line 12) of the description has been filed pursuant to Rule 88 EPC. A decision on the request will be taken during the proceedings before the Examining Division (Guidelines for Examination in the EPO, A-V, 2.2).

(30) Priority: **06.06.86 JP 130149/86**

(43) Date of publication of application:
**09.12.87 Bulletin 87/50**

(84) Designated Contracting States:
**CH DE FR GB IT LI NL SE**

(71) Applicant: **HITACHI, LTD.**
**6, Kanda Surugadai 4-chome**
**Chiyoda-ku Tokyo 101(JP)**

(72) Inventor: **Koubuchi, Yasushi**
**Nikken Moriyama Apartment 204**
**17-1, Moriyamamacho-3-chome**
**Hitachi-shi(JP)**
Inventor: **Onuki, Jin**
**6-1, Kujicho-1-chome**
**Hitachi-shi(JP)**
Inventor: **Koizumi, Masahiro**
**19-5-102, Ishinazakacho-1-chome**
**Hitachi-shi(JP)**

(74) Representative: **Patentanwälte Beetz sen. -**
**Beetz jun. Timpe - Siegfried -**
**Schmitt-Fumian**
**Steinsdorfstrasse 10**
**D-8000 München 22(DE)**

(54) **Semiconductor device having a diffusion barrier and process for its production.**

(57) This invention provides a semiconductor device having an electrode conductor layer (6) on a semiconductor substrate (1) through the medium of a diffusion barrier layer (5) which is formed of an amorphous material having a higher crystallization temperature than the heat treatment temperature for the semiconductor device, and a process for manufacturing this device.

According to this invention, an undesired reaction between the metal of the electrode conductor layer (6) and the material of the semiconductor substrate (1) and the diffusion of the electrode conductor material into the semiconductor substrate (1) can be prevented, whereby a semiconductor device having a high thermal reliability can be obtained.

## F I G . I

## Semiconductor device and process for its production

This invention relates to a semiconductor device having electrode conductors formed of aluminum or an aluminum-silicon alloy suitable for integrated circuits (ICs) and large scale integrated circuits (LSIs), and a process for manufacturing this device.

When an electronic circuit is constructed by connecting transistors, diodes etc. formed in a silicon semiconductor substrate, usually aluminum film conductors are used, and a heat treatment is applied, after the interconnecting conductors have been formed, for the purpose of decreasing the contact resistance between the conductors and the substrate. The heat treatment is carried out at a temperature which does not cause melting of the aluminum conductors, usually at about 400 to 500 °C.

It is known that the silicon of the silicon semiconductor substrate and the aluminum conductors diffuse into each other during heat treatment. If aluminum diffuses up to the junction part which forms the transistors, diodes, etc., the junction is broken, and resultantly such an electronic circuit cannot be used.

It is already known to use conductors of an aluminum-silicon alloy in which silicon is contained corresponding to the solid solubility limit for aluminum or more, in order to prevent the mutual diffusion of the aluminum of the conductors and the silicon of the semiconductor substrate. However, satisfactory results could not been obtained by this method.

JP-A-48249/82 discloses to provide a titanium nitride layer at the interface between a silicon semiconductor substrate and an aluminum conductor to prevent the mutal diffusion of the two. Further, JP-A-210838/85 discloses to form a platinum silicide layer or a palladium silicide layer at the interface between a silicon semiconductor substrate and an aluminum conductor for the same purpose.

However, according to a study in connection with the present inventors, when a titanium nitride layer is provided, it is ineffective unless it has a large thickness of about several micrometers. If it has only a small thickness of about 0,1 $\mu$m, aluminum and silicon diffuse into each other through the grain boundaries of the titanium nitride matrix. A thick titanium nitride layer of several micrometers thickness, however, is unfavorable because it causes an increased contact resistance.

When, on the other side, a platinum silicide layer or a palladium silicide layer is provided, e.g. according to JP-A-210838/85, by forming a platinum layer or a palladium layer on a silicon semiconductor substrate and then depositing silicon thereon and reacting the two with each other, this production process is complicated and not suitable for practical application. Further, the use of platinum or palladium increases the costs of the resulting semiconductor device.

The object of this invention is to provide a semiconductor device which has a novel diffusion barrier layer to give a diffusion prevention effect higher than that obtainable by the prior art methods mentioned above, and a process for manufacturing that device.

The above-mentioned object is achieved according to claims 1 and 17. The dependent claims refer to preferred embodiments.

According to the conception of the invention, the diffusion barrier layer, an amorphous material is used which has a higher crystallization temperature than the temperature of the heat treatment applied after the formation of an electrode conductor layer. More specifically, an amorphous material is used which has a crystallization temperature higher than the melting point of the electrode conductor material, because the heat treatment after the formation of the electrode conductor layer is carried out at a temperature not more than the melting point of the electrode conductor material.

This invention is based on the finding that as long as a crystalline material is used for the diffusion barrier layer, diffusion takes place through the crystal grain boundaries.

Based on that finding, the present invention provides a semiconductor device in which the diffusion barrier layer is formed with an amorphous material.

The semiconductor device according to the invention comprises a semiconductor substrate having integrated circuits therein, a diffusion barrier layer formed on said substrate, and an electrode conductor layer formed of aluminum or an aluminum-silicon alloy on said diffusion barrier layer; it is characterized in that the diffusion barrier layer is formed of an amorphous material having a crystallization temperature which is higher than the temperature of the heat treatment applied to the semiconductor device after formation of the electrode conductor layer.

The method according to the invention for manufacturing the semiconductor device comprises the following basic steps:

(A) providing a semiconductor substrate,

(B) providing the respective doped regions of desired conductivity type and impurity/dopant concentration corresponding to the desired integrated circuit structures

(C) forming an insulating oxide film on the surface of the semiconductor body including the desired contact holes,

(D) depositing a diffusion barrier layer on the insulating oxide film,

(E) depositing an electrode conductor layer consisting of aluminum or an aluminum-silicon alloy on the diffusion barrier layer,

(F) eventually thereafter removing selected parts of the diffusion barrier layer and the electrode conductor layer until to reach the insulating oxide film, and

(G) applying a heat treatment at a temperature below the melting temperature of the electrode conductor material, characterized in that in step (D) a diffusion barrier layer consisting of an amorphous material is deposited, the crystallization temperature of which is higher than the temperature of the heat treatment applied in step (G).

Diffusion barrier layers of the prior art comprising titanium nitride, or platinum silicide or palladium silicide, have the effect of suppressing, to some extent, the diffusion between the aluminum conductors and the silicon semiconductor substrate. However, the crystal grain boundaries of the diffusion barrier layer act as diffusion paths during the heat treatment conducted after the formation of the electrode conductor layer, inevitably giving rise to diffusion to some extent. Increasing the thickness of the diffusion barrier layer to prevent the diffusion through its grain boundaries causes an increase in the contact resistance between the aluminum and the silicon semiconductor substrate.

When an amorphous material having no crystal grain boundaries which would constitute diffusion paths, is used for the diffusion barrier layer, and further when the crystallization temperature of the amorphous material is higher than the heat treatment temperature of the semiconductor device, the amorphous diffusion barrier layer is thermodynamically stable and can effectively prevent the diffusion between the electrode conductor and the semiconductor substrate. Further, since a very high diffusion prevention effect is obtained by this method, the thickness of the diffusion barrier layer can be decreased, and resultantly the contact resistance between aluminum and the substrate can be lowered.

Experiments conducted by using various amorphous materials have revealed that the diffusion barrier layer with a thickness of 0,1 μm or less gives a sufficient effect and also causes no problems with respect to the contact resistance. The amorphous material diffusion barrier layer has preferably a thickness of 0,003 to 0,3 μm. It is difficult to prepare a thin layer of a thickness below 0,003 μm, which also is poor in reliability in respect of diffusion prevention. A thick layer of more than 0,3 μm in thickness is unnecessary and makes the formation of the device on the electrode conductors rather difficult.

On investigation of amorphous materials which are thermodynamically stable and do not crystalize at the heat treatment temperature for the semiconductor device, it has been found that satisfactory results can be obtained by combining two or more kinds of metals of a high melting point. More specifically, satisfactory results have been obtained by combination of metals having a melting point of 1000 °C or more. Examples of such metals are beryllium, boron, silicon, titanium, manganese, iron, cobalt, nickel, zirconium, niobium, molybdenum, copper, yttrium, ruthenium, rhodium, palladium, hafnium, tantalum, tungsten, rhenium, iridium, thorium, samarium, gadolinium, and terbium. Amorphous materials comprising an alloy, or a compound, of two or more metals selected from these are satisfactory for the diffusion barrier layer. A single component alone cannot form an amorphous material and hence is ineffective.

The above-mentioned metallic elements are preferably used in a combination which allows a eutectic reaction to take place and is in a eutectic composition or in the neighborhood thereof. An alloy having a eutectic composition or a composition near thereto can be readily turned from the gas phase directly into the solid phase by quenching, and hence tends to become amorphous.

Amorphous materials of the following combinations were tested in practice and all showed a fully satisfactory performance. Accordingly, the following combinations are very favorable:

Combinations of cobalt and titanium, copper and titanium; iron and zirconium; hafnium and cobalt; hafnium and nickel; nickel and zirconium; titanium and nickel; zirconium and cobalt; zirconium and palladium; titanium, beryllium and zirconium; and zirconium, beryllium and niobium.

Table 1 shows the eutectic composition and the preferred component composition range of alloys of the above-mentioned combinations.

Table 1

| Diffusion barrier layer material | Preferred component composition range (atomic %) | Eutectic composition (atomic %) |
|---|---|---|
| Co-Ti alloy | Co - 10-30% Ti | Co - 22% Ti |
| Cu-Ti alloy | Cu - 15-50% Ti | Cu - 30% Ti |
| Fe-Zr alloy | Fe - 5-20% Zr | Fe - 10% Zr |
| Fe-Zr alloy | Fe - 60-80% Zr | Fe - 76% Zr |
| Hf-Co alloy | Hf - 50-70% Co | Hf - 67% Co |
| Hf-Ni alloy | Hf - 50-70% Ni | Hf - 67% Ni |
| Ti-Ni alloy | Ti - 15-35% Ni | Ti - 25% Ni |
| Zr-Co alloy | Zr - 5-12% Co | Zr - 8% Co |
| Zr-Ni alloy | Zr - 10-50% Ni | Zr - 24% Ni |
| Zr-Pd alloy | Zr - 30-80% Pd | Zr - 50% Pd |
| Ti-Be-Zr alloy | Ti - 24-55% Be - 5-30% Zr | Ti - 40% Be - 10% Zr |
| Zr-Be-Nb alloy | Zr - 15-45% Be - 5-30% Nb | Zr - 30% Be - 10% Nb |

0 248 445

Amorphous alloys or amorphous compounds can be formed by depositing the alloys or compounds onto a semiconductor substrate by means of sputtering. The alloys or compounds can be made amorphous by utilizing the effect of quenching when they are deposited onto the semiconductor substrate from a plasma state.

Amorphous alloys or amorphous compounds can be formed, besides by sputtering, also by means of vapor deposition or chemical vapor deposition (CVD).

In the following, the invention will be described with reference to examples and the accompanying drawings.

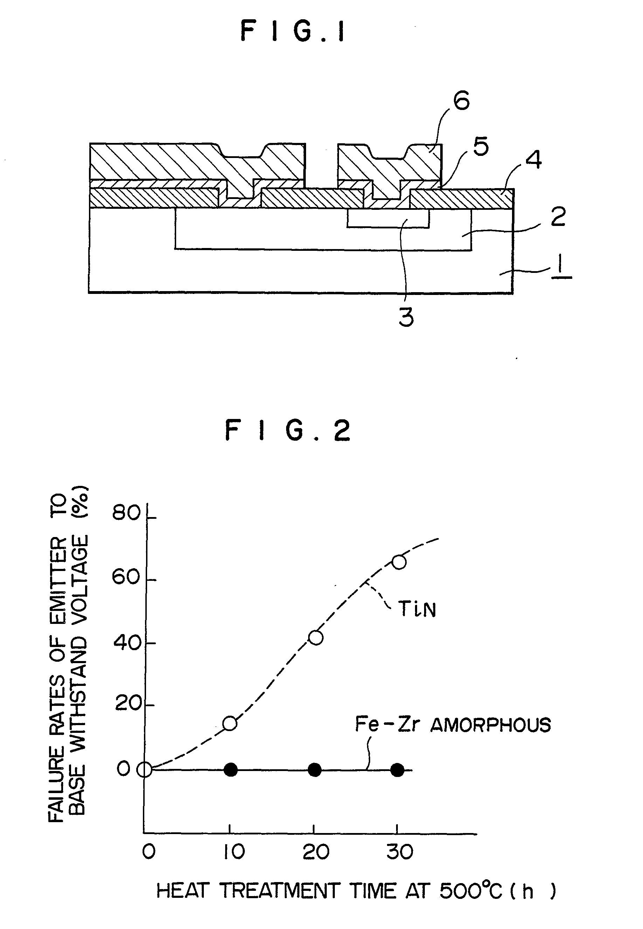

Fig. 1 is a sectional structural representation of one embodiment of this invention. Fig. 2 is a characteristics diagram showing results of measurement of the thermal resistance via the emitter-to-base withstand voltage of the device shown in Fig. 1 in dependence of the heat treatment time in comparison with those obtained by the prior art method.

Fig. 1 is a sectional view of a transistor to which this invention has been applied. An n-type silicon substrate 1 has a p-type base region 2 and an n-type emitter region 3 on its surface. A silicon oxide film 4 is formed on the surface of the p-type base region and the n-type emitter region. The formation of the silicon oxide film was conducted by heating the silicon substrate at about 1000 °C with thermal oxidation of its surface. The silicon oxide film has a thickness of 0,5 $\mu$m. Then, a contact hole was formed in the silicon oxide film 4, and a diffusion barrier layer 5 comprising an amorphous material was formed thereon in a thickness of 0,01 $\mu$m, and then a aluminum electrode conductor layer 6 was formed in a thickness of 0,8 $\mu$m on the diffusion barrier layer 5. Combinations having the component compositions shown in Table 2 were chosen for the amorphous materials. The materials shown in Table 2 were sputtered and turned into the amorphous state by utilizing the effect of quenching when deposited from their plasma state onto the silicon substrate and the silicon oxide film. The sputtering conditions were the same for the formation of the diffusion barrier layer and for the formation of the aluminum conductor layer, namely an argon gas pressure of 0,5 Pa and an RF output power of 2 kW.

Thereafter, parts of the amorphous material and of the aluminum conductor layer 6 were dry-etched until to reach the silicon oxide film 4 by means of commonly used photolithography. The etching conditions were as follows: $CCl_4$ gas pressure of 5 Pa and an RF output power of 100 W. The reaction between the silicon semiconductor substrate or the silicon of the base or emitter region, respectively, and the aluminum conductor layer 6 at the contact holes of the silicon oxide film 4 can be suppressed by thus providing a diffusion barrier layer. Further, since the diffusion of aluminum (Al) atoms into the silicon semiconductor substrate can be prevented by means of the diffusion barrier layer 5 formed of the amorphous material, the thermal reliability of the characteristics of the emitter base junction can be drastically improved.

In the combination of iron (Fe) with zirconium (Zr), it is particularly preferable to control the content of Zr to 9-11 atomic % and the thickness of the amorphous layer to 20 to 100 nm (200 to 1000 Å).

Table 2 shows the "thermal resistance temperature" and the electric resistance of the ohmic contact part of the electrode conductor and the silicon substrate for cases where various diffusion barrier layer materials were used. The "thermal resistance temperature" is the temperature at which an emitter-base junction failure rate of 1 % occurs after one hour of heating at that temperature, whereby higher thermal resistance temperatures indicate a better performance. The electric resistance is the value obtained after one hour of heating at 450 °C, whereby lower values correspond to a better performance.

Table 2 shows the thermal resistance temperature and the electric resistance also for a case where a titanium nitride layer was formed to a thickness of 0,01 $\mu$m as the diffusion barrier layer and a case where an aluminum-1,8 atomic % silicon alloy conductor was used without a diffusion barrier layer (comparative examples). The titanium nitride layer was formed by means of sputtering using a titanium conductor and applying an $N_2$ pressure of 5 Pa and an RF output power of 2 kW.

Table 2

| Diffusion barrier layer material (atomic %) | Thermal resistance temperature (°C) | Electric resistance ($\Omega/\mu m^2$) |
|---|---|---|
| Co-22%Ti | 505 | 80 |
| Cu-33%Ti | 480 | 95 |
| Fe-10%Zr | 520 | 90 |
| Fe-67%Zr | 535 | 85 |
| Hf-50%Co | 495 | 100 |
| Hf-50TNi | 475 | 105 |
| Ti-33%Ni | 500 | 120 |
| Zr-10%Co | 510 | 85 |
| Zr-50%Ni | 490 | 95 |
| Zr-30%Pd | 485 | 105 |
| Ti-40% Be-10%Zr | 510 | 85 |
| Zr-30% Be-10% Nb | 530 | 80 |
| No diffusion * barrier layer | 380 | 1300 |
| TiN * | 400 | 200 |

\* Comparative examples

Table 3 shows the failure rate of the emitter-base junction after 1 h, 10 h and 100 h of heating at 450 °C after formation of the electrode conductor.

# 0 248 445

Table 3

| Diffusion barrier layer material (atomic %) | Failure rate of emitter-to-base junction after heating at 450°C | | |
|---|---|---|---|
| | 1 h | 10 h | 100 h |
| Co-22%Ti | 0 | 0 | 0 |
| Cu-33%Ti | 0 | 0,2 | 1 |
| Fe-10%Zr | 0 | 0 | 0 |
| Fe-67%Zr | 0 | 0 | 1 |
| Hf-50%Co | 0 | 0,2 | 1 |
| Hf-50%Ni | 0 | 0,4 | 1 |
| Ti-33%Ni | 0 | 0 | 0 |
| Zr-10%Co | 0 | 0 | 0 |
| Zr-50%Ni | 0 | 0,4 | 1 |
| Zr-30%Pd | 0 | 0,1 | 0,4 |
| Ti-40% Be-10% Zr | 0 | 0 | 0 |
| Zr-30% Be-10% Nb | 0 | 0 | 0 |
| No diffusion barrier layer | 5 | 23 | 100 |
| TiN | 0,2 | 2 | 13 |

The results of Table 3 show that semiconductor devices having diffusion barrier layers formed of amorphous materials exhibit low failure rates of the emitter-to-base junction as compared with devices provided with a TiN layer as the diffusion barrier layer and devices having no diffusion barrier layer and where an Al-1,8 atomic % Si alloy conductor has been used.

**Claims**

1. A semiconductor device comprising a semiconductor substrate (1) having integrated circuits therein, a diffusion barrier layer (5) formed on said substrate, and an electrode conductor layer (6) formed of aluminum or an aluminum-silicon alloy on said diffusion barrier layer (5),
characterized in that the diffusion barrier layer (5) is formed of an amorphous material having a crystallization temperature which is higher than the temperature of the heat treatment applied to the semiconductor device after formation of the electrode conductor layer (6) (Fig. 1).

2. The semiconductor device according to claim 1, characterized in that the diffusion barrier layer (5) is formed of an amorphous material having a crystallization temperature which is higher than the melting temperature of the electrode conductor material used.

3. The semiconductor device according to claim 1 or 2, characterized in that the diffusion barrier layer (5) has a thickness of 0,003 to 0,3 $\mu$m.

7

4. The semiconductor device according to one of claims 1 to 3, characterized in that the amorphous material of the diffusion barrier layer (5) is an alloy, or a compound, of at least two metals selected from beryllium, boron, silicon, titanium, manganese, iron, cobalt, nickel, copper, yttrium, zirconium, niobium, molybdenum, ruthenium, rhodium, palladium, hafnium, tantalum, tungsten, rhenium, iridium, thorium, samarium, gadolinium, and terbium.

5. The semiconductor device according to one of claims 1 to 4, characterized in that the diffusion barrier layer (5) is an amorphous cobalt-10 to 30 atomic % titanium alloy.

6. The semiconductor device according to one of claims 1 to 4, characterized in that the diffusion barrier layer (5) is an amorphous copper-15 to 50 atomic % titanium alloy.

7. The semiconductor device according to one of claims 1 to 4, characterized in that the diffusion barrier layer (5) is an amorphous iron-5 to 20 atomic % zirconium alloy.

8. The semiconductor device according to one of claims 1 to 4, characterized in that the diffusion barrier layer (5) is an amorphous iron-60 to 80 atomic % zirconium alloy.

9. The semiconductor device according to one of claims 1 to 4, characterized in that the diffusion barrier layer (5) is an amorphous hafnium-50 to 70 atomic % cobalt alloy.

10. The semiconductor device according to one of claims 1 to 4, characterized in that the diffusion barrier layer (5) is an amorphous hafnium-50 to 70 atomic % nickel alloy.

11. The semiconductor device according to one of claims 1 to 4, characterized in that the diffusion barrier layer (5) is an amorphous titanium-15 to 35 atomic % nickel alloy.

12. The semiconductor device according to one of claims 1 to 4, characterized in that the diffusion barrier layer (5) is an amorphous zirconium-5 to 12 atomic % cobalt alloy.

13. The semiconductor device according to one of claims 1 to 4, characterized in that the diffusion barrier layer (5) is an amorphous zirconium-10 to 50 atomic % nickel alloy.

14. The semiconductor device according to one of claims 1 to 4, characterized in that the diffusion barrier layer (5) is an amorphous zirconium-30 to 80 atomic % palladium alloy.

15. The semiconductor device according to one of claims 1 to 4, characterized in that the diffusion barrier layer (5) is an amorphous titanium-24 to 55 atomic % beryllium-5 to 30 atomic % zirconium alloy.

16. The semiconductor device according to one of claims 1 to 4, characterized in that the diffusion barrier layer (5) is an amorphous zirconium-15 to 45 atomic % beryllium-5 to 30 atomic % niobium alloy.

17. A method for manufacturing the semiconductor device according to one of claims 1 to 16, comprising the following principal steps:
(A) providing a semiconductor substrate (1),
(B) providing the respective doped regions (2, 3) of desired conductivity type and impurity/dopant concentration corresponding to the desired integrated circuit structures
(C) forming an insulating oxide film (4) on the surface of the semiconductor body including the desired contact holes,
(D) depositing a diffusion barrier layer (5) on the insulating oxide film (4),
(E) depositing an electrode conductor layer (6) consisting of aluminum or an aluminum-silicon alloy on the diffusion barrier layer (5),
(F) eventually thereafter removing selected parts of the diffusion barrier layer (5) and the electrode conductor layer (6) until to reach the insulating oxide film (4),
and
(G) applying a heat treatment at a temperature below the melting temperature of the electrode conductor material,
characterized in that in step (D) a diffusion barrier layer (5) consisting of an amorphous material is deposited, the crystallization temperature of which is higher than the temperature of the heat treatment applied in step (G).

18. The process according to claim 17, characterized in that a silicon semiconductor substrate (1) is used in step (A).

19. The process according to claim 17 or 18, characterized in that integrated circuits and/or large scale integrated circuits are provided in the semiconductor substrate (1) in steps (B).

20. The process according to one of claims 17 to 19, characterized in that the steps (B) are carried out according to a planar process.

21. The process according to one of claims 17 to 20, characterized in that the insulating oxide film (4) is formed in step (C) by thermal oxidation.

22. The process according to one of claims 17 to 21, characterized in that step (F) is carried out by dry etching.

23. The process according to one of claims 17 to 22, characterized in that the diffusion barrier layer (5) and/or the electrode conductor layer (6) are deposited in steps (D) and (E), respectively, by sputtering.

24. The process according to one of claims 17 to 23, characterized in that in step (D) the diffusion barrier layer (5) is deposited by vapor deposition or chemical vapor deposition.

25. The process according to one of claims 17 to 24, characterized in that in step (D) a combination of at least two of the following metals is used: beryllium, boron, silicon, titanium, manganese, iron, cobalt, nickel, zirconium, niobium, molybdenum, copper, yttrium, ruthenium, rhodium, palladium, hafnium, tantalum, tungsten, rhenium, iridium, thorium, samarium, gadolinium, and terbium.

26. The process according to one of claims 17 to 25, characterized in that in step (D) at least one of the following alloys is used:

Co-Ti
Cu-Ti
Fe-Zr
Hf-Co
Hf-Ni
Ti-Ni
Zr-Co
Zr-Ni
Zr-Pd
Ti-Be-Zr
Zr-Be-Nb.

27. The process according to claim 26, characterized in that in step (D) at least one of the following alloys is used in the indicated compositions (atomic %):

Co - 10 - 30 % Ti
Cu - 15 - 50 % Ti
Fe - 5 - 20 % Zr
Fe - 60 - 80 % Zr
Hf - 50 - 70 % Co
Hf - 50 - 70 % Ni
Ti - 15 - 35 % Ni
Zr - 5 - 12 % Co
Zr - 10 - 50 % Ni
Zr - 30 - 80 % Pd
Ti - 24 - 55 % Be - 5 - 30 % Zr
Zr - 15 - 45 % Be - 5 - 30 % Nb.

28. The process according to one of claims 17 to 27, characterized in that in step (D) eutectic compositions are applied.

29. The process according to claim 28, characterized in that in step (D) at least one of the following metal alloys or compounds is used in the indicated eutectic compositions (atomic %):

Co - 22 % Ti
Cu - 30 % Ti
Fe - 10 % Zr
Fe - 76 % Zr
Hf - 67 % Co
Hf - 67 % Ni
Ti - 25 % Ni
Zr - 8 % Co
Zr - 24 % Ni
Zr - 50 % Pd
Ti - 40 % Be - 10 % Zr
Zr - 30 % Be - 10 % Nb.

30. The process according to one of claims 17 to 29, characterized in that in step (D) the diffusion barrier layer (5) is deposited in a thickness of 0,003 to 0,3 $\mu$m.

## F I G . I

## F I G . 2

**BEETZ & PARTNER** · Patentanwälte
European Patent Attorneys

Dipl.-Ing. R. BEETZ sen.
Dr.-Ing. R. BEETZ jun.
Dr.-Ing. W. TIMPE
Dipl.-Ing. J. SIEGFRIED
Priv.-Doz. Dipl.-Chem. Dr. rer. nat. W. SCHMITT-FUMIAN

Dipl.-Ing. K. LAMPRECHT † 1981

EPA EPO-OEB
DG 1
Reçu:

1 8 AOUT 1987

BEETZ & PARTNER · Steinsdorfstr. 10 · D-8000 München 22

Europäisches Patentamt

Erhardtstraße 27

M ü n c h e n

EPA-EPO-OEB
MÜNCHEN
Empfang bestätigt
Receipt acknowledged
Accuse reception

CD

EP 87108180.8 of June 5, 1987
Hitachi, Ltd.
-----------------------------------

Ihr Zchn.
Your Ref.

Unser Zchn.          81-39.974EP-SF-Bk
Our Ref.

München   -7. AUG. 1987

We submit herewith

a new specification page 2

on which a clerical error has been corrected in line 12
('mutual').

We ask to consider this new page for the further
procedure.

Very truly yours,
Patentanwälte
BEETZ & PARTNER

W. Schmitt-Fumian

Encl.
New page 2
in triplicate

2 4 AOUT 1987
J.G. KAUFMANN

Telefon (089) 227201 - 227244 - 295910 · Telex 522048 · Telecopy 293963 · Telegramm Allpat® München
Postscheck: München 53358-804 · Dresdner Bank AG. München, Konto 3911603 · Bayer. Vereinsbank München Konto 563443